# EUROPEAN PATENT APPLICATION

(11) **EP 4 625 501 A1**
(43) Date of publication of application: **01.10.2025**
(21) Application number: 24773972.5
(22) Date of filing: 13.03.2024
(51) Int. Cl.: H01L 33/08

(54) **LIGHT-EMITTING DIODE EPITAXIAL STRUCTURE, DISPLAY PANEL AND ELECTRONIC DEVICE**

(30) Priority: 17.03.2023 CN 202310309060
(71) Applicant: Huawei Technologies Co., Ltd., Shenzhen, Guangdong 518129 (CN)
(72) Inventor: LIU, Jinqiang, Shenzhen, Guangdong 518129 (CN); ZHANG, Li, Shenzhen, Guangdong 518129 (CN); JIANG, Fulong, Shenzhen, Guangdong 518129 (CN); LIANG, Chaorong, Shenzhen, Guangdong 518129 (CN)
(74) Representative: Gill Jennings & Every LLP
(86) International application number: PCT/CN2024/081322
(87) International publication number: WO 2024/193406

(57) **Abstract**

Embodiments of this application provide a light-emitting diode epitaxial structure, a display panel, and an electronic device, and relate to the field of display technologies, to reduce process limitation on color display that is implemented by using an LED. The light-emitting diode epitaxial structure includes a first color epitaxial layer and a second color epitaxial layer that are stacked. Any one of the first color epitaxial layer and the second color epitaxial layer includes a first stress buffer layer, a first carrier injection layer, a light-emitting layer, and a second carrier injection layer that are sequentially stacked in a first direction. The light-emitting layers in the first color epitaxial layer and the second color epitaxial layer are light-emitting layers of different colors. One of the first carrier injection layer and the second carrier injection layer is an electron injection layer, and the other of the first carrier injection layer and the second carrier injection layer is a hole injection layer.

## Description

This application claims priority to Chinese Patent Application No. 202310309060.0, filed with the China National Intellectual Property Administration on March 17, 2023 and entitled "LIGHT-EMITTING DIODE EPITAXIAL STRUCTURE, DISPLAY PANEL, AND ELECTRONIC DEVICE", which is incorporated herein by reference in its entirety.

### TECHNICAL FIELD

This application relates to the field of display technologies, and in particular, to a light-emitting diode epitaxial structure, a display panel, and an electronic device.

### BACKGROUND

With development of display technologies, the display technologies are increasingly widely used. For example, near-eye display required by augmented reality (Augmented Reality, AR) and virtual reality (Virtual Reality, VR), compared with other display, has a greatly reduced display screen size and improved resolution, and needs to be used together with an optical component. When the display screen size is greatly reduced and the display resolution is improved, a size of a single pixel is also reduced. Silicon-based semiconductor display technologies, such as liquid crystal on silicon (Liquid Crystal on Silicon, LCOS), silicon-based organic light-emitting diode (Si-Organic Light-Emitting Diode, Si-OLED), and micro light-emitting diode (Micro Light-Emitting Diode, Micro LED), are considered as new display technologies applicable to near-eye displays (Near-Eye Displays, NEDs). For micro LED display, epitaxial wafer growth can implement only single-wavelength display. In order to implement color display through the Micro LED, one way is to first fabricate R, G, and B monochromatic LED display chips or monochromatic LED display devices separately, and then transfer the display chips to a drive backplane by using technologies such as mass transfer and/or bonding, so as to implement full-color display. Currently, however, these display chip transfer technologies are highly limited in process.

### SUMMARY

The technical solutions of this application provide a light-emitting diode epitaxial structure, a display panel, and an electronic device, to reduce process limitation on color display that is implemented by using an LED.

According to a first aspect, a light-emitting diode epitaxial structure is provided, including: a first color epitaxial layer and a second color epitaxial layer that are stacked. Any one of the first color epitaxial layer and the second color epitaxial layer includes a first stress buffer layer, a first carrier injection layer, a light-emitting layer, and a second carrier injection layer that are sequentially stacked in a first direction. The light-emitting layers in the first color epitaxial layer and the second color epitaxial layer are light-emitting layers of different colors. One of the first carrier injection layer and the second carrier injection layer is an electron injection layer, and the other of the first carrier injection layer and the second carrier injection layer is a hole injection layer.

In a possible implementation, at least one of the first color epitaxial layer and the second color epitaxial layer further includes an N-type current diffusion layer located on a side that is of the electron injection layer and that is away from the light-emitting layer, to improve diffusion uniformity of an injection current on an x-y horizontal plane, improve light-emitting uniformity of the epitaxial layer, and improve process integration.

In a possible implementation, at least one of the first color epitaxial layer and the second color epitaxial layer further includes a P-type current diffusion layer located on a side that is of the hole injection layer and that is away from the light-emitting layer, to improve diffusion uniformity of injection holes on the x-y horizontal plane, improve light-emitting uniformity of the epitaxial layer, and improve process integration.

In a possible implementation, at least one of the first color epitaxial layer and the second color epitaxial layer further includes a functional layer located on a side that is of the P-type current diffusion layer and that is away from the light-emitting layer. The functional layer is configured to reduce contact resistance and/or configured for wavelength-selective light transmission. The P-type current diffusion layer needs to form good electrical properties with an upper film layer. Therefore, the functional layer used to reduce contact resistance can improve electrical contact effect, the functional layer with the wavelength-selective light transmission function can implement selective transmission in a specific wide wavelength range as required, to reduce an adverse impact caused by unnecessary light.

In a possible implementation, the N-type current diffusion layer includes a two-dimensional electron gas (2DEG) structure, to improve diffusion uniformity of the injection current on the x-y horizontal plane.

In a possible implementation, the first carrier injection layer is the electron injection layer, the second carrier injection layer is the hole injection layer, and the N-type current diffusion layer includes an electron-doped gallium nitride GaN layer and an electron-doped aluminum gallium nitride AlGaN layer that are sequentially stacked and adjacently disposed in the first direction. The two layers can implement the two-dimensional electron gas structure. Moreover, when SF₆ gas is subsequently used to etch the epitaxial structure to form an electrode hole, the SF₆ gas can remove GaN through etching but cannot etch AlGaN. That is, an etching endpoint position is determined by using adjacent GaN and AlGaN, so that an electrode signal is led out through the electrode hole formed through etching, thereby reducing process difficulty.

In a possible implementation, the light-emitting layer in the first color epitaxial layer is a red light-emitting layer. A stress release layer is disposed between the first stress buffer layer and the first carrier injection layer of the first color epitaxial layer. A material of the stress release layer is electron-doped gallium nitride. Another required doping may be added in a process of fabricating the red light-emitting layer through stress release action, to improve light-emitting effect of the red light-emitting layer.

In a possible implementation, a thickness range of the stress release layer is [0.1, 3] µm.

In a possible implementation, the light-emitting diode epitaxial structure further includes at least two bonding layers located between the first color epitaxial layer and the second color epitaxial layer.

In a possible implementation, the light-emitting diode epitaxial structure further includes a third color epitaxial layer located on a side that is of the second color epitaxial layer and that is away from the first color epitaxial layer. The third color epitaxial layer includes a first stress buffer layer, a first carrier injection layer, a light-emitting layer, and a second carrier injection layer that are sequentially stacked in the first direction. The light-emitting layers of any two of the first color epitaxial layer, the second color epitaxial layer, and the third color epitaxial layer are light-emitting layers of different colors.

In a possible implementation, a material of the light-emitting layer is indium gallium nitride multi-quantum well.

In a possible implementation, a material of the first stress buffer layer is gallium nitride; a material of the first carrier injection layer is electron-doped gallium nitride; and a material of the second carrier injection layer is hole-doped gallium nitride.

In a possible implementation, the P-type current diffusion layer includes a material that forms, with the hole injection layer, a tunneling junction under forward bias, to improve diffusion uniformity of the injection holes on the x-y horizontal plane.

In a possible implementation, the P-type current diffusion layer is electron-doped gallium nitride or electron-doped indium gallium nitride. A material of the functional layer is electron-doped gallium nitride, or the functional layer is a distributed Bragg reflector structure formed by a combination of electron-doped indium aluminum nitride and gallium nitride.

In a possible implementation, the light-emitting diode epitaxial structure further includes a second stress buffer layer located between the stress release layer and the first carrier injection layer. A material of the stress release layer is electron-doped gallium nitride, and materials of the first stress buffer layer and the second stress buffer layer are unintentionally doped gallium nitride.

According to a second aspect, a display panel is provided, including the foregoing light-emitting diode epitaxial structure.

In a possible implementation, the display panel includes a plurality of light-emitting diode epitaxial structures arranged in an array. In each light-emitting diode epitaxial structure, the first color epitaxial layer has a first electrode hole, and the first electrode hole penetrates through the first color epitaxial layer in the first direction. A first conductive structure is disposed in the first electrode hole, and the first conductive structure extends from an end that is of the first color epitaxial layer and that is away from the second color epitaxial layer to the second color epitaxial layer. An insulation material is filled between the first conductive structure and a side wall of the first electrode hole. In each light-emitting diode epitaxial structure, the second color epitaxial layer has a second electrode hole, the second electrode hole penetrates through the second color epitaxial layer in the first direction. A second conductive structure is disposed in the second electrode hole, and the second conductive structure extends from an end that is of the second color epitaxial layer and that is away from the first color epitaxial layer to the first color epitaxial layer. An insulation material is filled between the second conductive structure and a side wall of the second electrode hole. The display panel further includes: a transparent conductive layer located on a side that is of the second color epitaxial layer and that is away from the first color epitaxial layer, where the transparent conductive layer is electrically connected to the second conductive structure in each light-emitting diode epitaxial structure, and the transparent conductive layer is electrically connected to an end that is of the second color epitaxial layer and that is close to the transparent conductive layer in each light-emitting diode epitaxial structure; and a drive electrode layer located on a side that is of the first color epitaxial layer and that is away from the second color epitaxial layer, where the drive electrode layer includes a first color subpixel electrode corresponding to the first color epitaxial layer in each light-emitting diode epitaxial structure, the first color subpixel electrode is correspondingly electrically connected to the first color epitaxial layer in the corresponding light-emitting diode epitaxial structure, the drive electrode layer includes a second color subpixel electrode corresponding to the second color epitaxial layer in each light-emitting diode epitaxial structure, and the second color subpixel electrode is correspondingly electrically connected to the first conductive structure in the corresponding light-emitting diode epitaxial structure.

In a possible implementation, the first color epitaxial layer and the second color epitaxial layer have a third electrode hole, and the third electrode hole penetrates through the first color epitaxial layer and the second color epitaxial layer in the first direction. A third conductive structure is disposed in the third electrode hole, and the third conductive structure extends from the end that is of the first color epitaxial layer and that is away from the second color epitaxial layer to the third color epitaxial layer. An insulation material is filled between the third conductive structure and a side wall of the third electrode hole. Both the second electrode hole and the second conductive structure penetrate through the third color epitaxial layer. The third color epitaxial layer has a fourth electrode hole, and the fourth electrode hole penetrates through the third color epitaxial layer in the first direction. A fourth conductive structure is disposed in the fourth electrode hole, and the fourth conductive structure extends from the second color epitaxial layer to an end that is of the third color epitaxial layer and that is away from the second color epitaxial layer. The third color epitaxial layer is located between the transparent conductive layer and the second color epitaxial layer. The transparent conductive layer is electrically connected to an end that is of the third color epitaxial layer and that is close to the transparent conductive layer in each light-emitting diode epitaxial structure. The transparent conductive layer is electrically connected to the fourth conductive structure in each light-emitting diode epitaxial structure. The drive electrode layer includes a third color subpixel electrode corresponding to the third color epitaxial layer in each light-emitting diode epitaxial structure, and the third color subpixel electrode is correspondingly electrically connected to the third conductive structure in the corresponding light-emitting diode epitaxial structure.

According to a third aspect, an electronic device is provided, including the foregoing display panel.

According to the light-emitting diode epitaxial structure, the display panel, and the electronic device in embodiments of this application, the light-emitting diode epitaxial structure, the display panel, and the electronic device include at least two monochromatic epitaxial layers that are stacked. Each monochromatic epitaxial layer includes the first stress buffer layer, the first carrier injection layer, the light-emitting layer, and the second carrier injection layer that are sequentially stacked as a minimum repetition unit. That is, color display is implemented by stacking the epitaxial layers of different colors. The color display can be implemented without transferring a monochromatic LED display chip by using a mass transfer technology, and a beam-combining prism or a quantum dot color conversion structure is not required, thereby reducing process limitation on the color display that is implemented by using an LED, and reducing process difficulty. The display panel is encapsulated to form a display module. The display module may be used as a display unit of an electronic device such as AR/VR helmet/glasses, a wearable device, or a mobile display device.

### BRIEF DESCRIPTION OF DRAWINGS

FIG. 1 is a diagram of an LED epitaxial structure including N monochromatic epitaxial layers according to an embodiment of this application;
FIG. 2 is a diagram of an LED epitaxial structure including two monochromatic epitaxial layers according to an embodiment of this application;
FIG. 3 is a diagram of an LED epitaxial structure including three monochromatic epitaxial layers according to an embodiment of this application;
FIG. 4 is a diagram of an LED epitaxial structure including four monochromatic epitaxial layers according to an embodiment of this application;
FIG. 5 is a diagram of another LED epitaxial structure including four monochromatic epitaxial layers according to an embodiment of this application;
FIG. 6 is a diagram of an LED epitaxial structure including three colors according to an embodiment of this application;
FIG. 7 is a diagram of another LED epitaxial structure including three colors according to an embodiment of this application;
FIG. 8 is a diagram of another LED epitaxial structure including three colors according to an embodiment of this application;
FIG. 9 is a diagram of another LED epitaxial structure according to an embodiment of this application;
FIG. 10 is a diagram of another LED epitaxial structure according to an embodiment of this application;
FIG. 11 is a diagram of another LED epitaxial structure according to an embodiment of this application;
FIG. 12 is a diagram of another LED epitaxial structure according to an embodiment of this application;
FIG. 13 is a diagram of another LED epitaxial structure according to an embodiment of this application;
FIG. 14 is a diagram of three independent epitaxial structures according to an embodiment of this application;
FIG. 15 is a diagram obtained by fabricating bonding layers on the structures in FIG. 14;
FIG. 16 is a diagram of two temporary substrates according to an embodiment of this application;
FIG. 17 is a diagram obtained by bonding a part of the structures in FIG. 15 with the two temporary substrates in FIG. 16;
FIG. 18 is a diagram obtained by removing a wafer substrate and a buffer layer from a structure in FIG. 17;
FIG. 19 is a diagram obtained by fabricating a bonding layer on a structure in FIG. 18;
FIG. 20 is a diagram obtained by bonding a second color epitaxial layer in FIG. 19 with a third color epitaxial layer in FIG. 15;
FIG. 21 is a diagram obtained by removing a wafer substrate of a temporary substrate from a structure in FIG. 20;
FIG. 22 is a diagram obtained by bonding a structure in FIG. 21 with a first color epitaxial layer in FIG. 19;
FIG. 23 is a diagram of a partial cross-sectional structure of a display panel according to an embodiment of this application;
FIG. 24 is a diagram of another LED epitaxial structure according to an embodiment of this application;
FIG. 25 is a diagram of a drive backplane according to an embodiment of this application;
FIG. 26 is a diagram of a combination of an LED epitaxial structure and a drive backplane according to an embodiment of this application;
FIG. 27 is a diagram obtained by etching a structure in FIG. 26;
FIG. 28 is a diagram obtained by depositing metal on a structure in FIG. 27;
FIG. 29 is a diagram obtained by etching and forming a conductive structure on a structure in FIG. 28;
FIG. 30 is a diagram of a display panel according to an embodiment of this application;
FIG. 31 is a diagram of another LED epitaxial structure according to an embodiment of this application; and
FIG. 32 is a diagram of a substrate including a plurality of display panels according to an embodiment of this application.

### DESCRIPTION OF EMBODIMENTS

Terms used in implementations of this application are merely used to explain specific embodiments of this application, but are not intended to limit this application.

Before embodiments of this application are described, a related technology and a technical problem thereof are first described.

Currently, process limitation of a mass transfer technology is high. For example, sizes of R, G, and B monochromatic display chips to be transferred are limited (for example, in the mass transfer technology, a transfer size is greater than or equal to 10 µm). Transfer efficiency is limited by a transfer yield and a transfer speed. Dedicated matching devices such as mass transfer and detection and repair devices are required.

Another solution for implementing LED color display is to separately fabricate R, G, and B monochromatic LED display panels, and combine light from the R, G, and B monochromatic display panels by using an optical module (for example, a beam-combining prism), to implement full-color display. However, the beam-combining prism needs to be customized for the R, G, and B display panels to improve utilization efficiency. Beam combination for R, G and B requires high alignment precision. An overall size of the beam-combining prism is large and costs are high.

Another solution for implementing LED color display is to fabricate a B monochromatic LED display panel, and fabricate a quantum dot color conversion structure at a corresponding position above the panel, to implement full-color display. However, a quantum dot material has a short service life, and an encapsulation structure needs to be added. The quantum dot material has problems of low color conversion efficiency and light leakage. A mass production solution for a quantum dot patterning based on 4000 PPI or higher is not mature.

An embodiment of this application provides a solution for implementing LED color display that is different from the content described above. The following describes this embodiment of this application in detail.

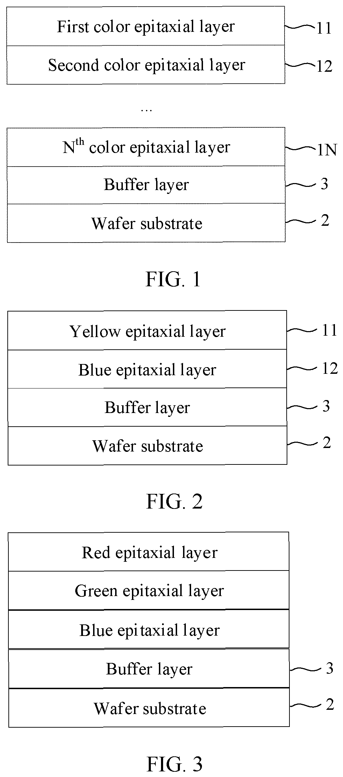

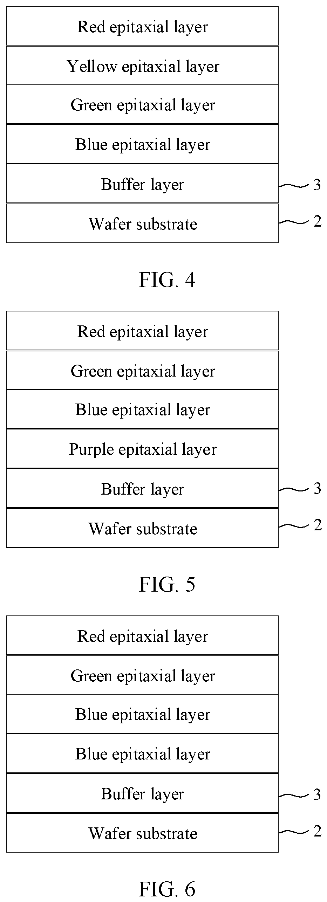

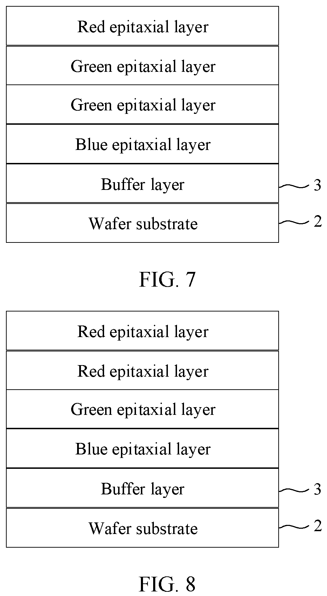

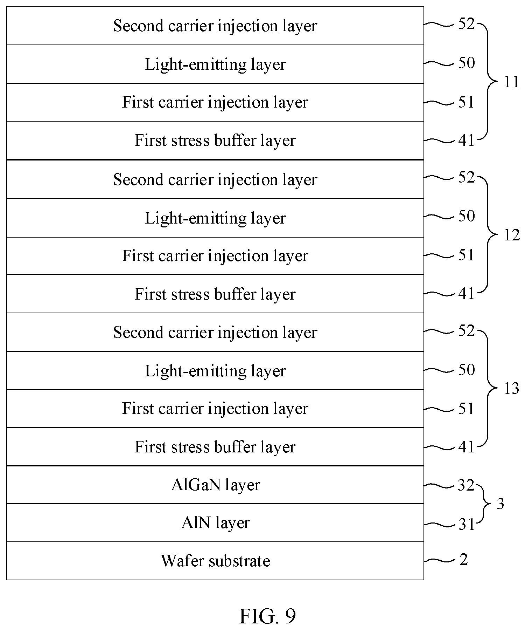

As shown in FIG. 1, an embodiment of this application provides a light-emitting diode LED epitaxial structure, including a wafer substrate 2, a buffer layer 3, and a plurality of monochromatic epitaxial layers 11 to 1N that are stacked. The plurality of monochromatic epitaxial layers include a first color epitaxial layer 11 and a second color epitaxial layer 12 that are stacked, where N>1, that is, the LED epitaxial structure includes at least two monochromatic epitaxial layers. In a structure shown in FIG. 2, N=2, and two monochromatic epitaxial layers are combined into an LED epitaxial structure. A first color epitaxial layer 11 is a yellow epitaxial layer, and a second color epitaxial layer 12 is a blue epitaxial layer. In a structure shown in FIG. 3, N=3, and three monochromatic epitaxial layers are combined into an LED epitaxial structure, for example, including a blue epitaxial layer, a green epitaxial layer, and a red epitaxial layer. In structures shown in FIG. 4 and FIG. 5, N=4, and four monochromatic epitaxial layers of different colors are combined into an LED epitaxial structure. For example, FIG. 4 shows a combination of a blue epitaxial layer, a green epitaxial layer, a yellow epitaxial layer, and a red epitaxial layer. FIG. 5 shows a combination of a blue epitaxial layer, a green epitaxial layer, a red epitaxial layer, and a purple epitaxial layer. In structures shown in FIG. 6, FIG. 7, and FIG. 8, N=4, and four monochromatic epitaxial layers are combined into an LED epitaxial structure. There are epitaxial layers of three colors in total. In other words, the four monochromatic epitaxial layers include two epitaxial layers of a same color, or an epitaxial layer of one color is a double-layer structure. The structure shown in FIG. 6 has two blue epitaxial layers, the structure shown in FIG. 7 has two green epitaxial layers, and the structure shown in FIG. 8 has two red epitaxial layers. As shown in FIG. 9, any one of a first color epitaxial layer 11 and a second color epitaxial layer 12 includes a first stress buffer layer 41, a first carrier injection layer 51, a light-emitting layer 50, and a second carrier injection layer 52 that are sequentially stacked in a first direction. The first direction is a downward direction in FIG. 9, and the first color epitaxial layer 11 and the second color epitaxial layer 12 are also arranged in the first direction. Light-emitting layers in the first color epitaxial layer 11 and the second color epitaxial layer 12 are light-emitting layers of different colors. For example, the light-emitting layer of the first color epitaxial layer 11 is a red light-emitting layer, and the light-emitting layer of the second color epitaxial layer 12 is a green light-emitting layer. One of the first carrier injection layer 51 and the second carrier injection layer 52 is an electron injection layer, and the other of the first carrier injection layer 51 and the second carrier injection layer 52 is a hole injection layer. For example, the first carrier injection layer 51 is the electron injection layer, and the second carrier injection layer 52 is the hole injection layer. In addition, the structure shown in FIG. 9 further includes a third color epitaxial layer 13. Similar to structures of other monochromatic epitaxial layers, the third color epitaxial layer 13 also includes a first stress buffer layer 41, a first carrier injection layer 51, a light-emitting layer 50, and a second carrier injection layer 52 that are sequentially stacked in the first direction. The light-emitting layers of any two of the first color epitaxial layer 11, the second color epitaxial layer 12, and the third color epitaxial layer 13 are light-emitting layers of different colors. For example, the light-emitting layer of the third color epitaxial layer 13 is a blue light-emitting layer. That is, the LED epitaxial structure includes at least two monochromatic epitaxial layers, where each monochromatic epitaxial layer includes the first stress buffer layer 41, the first carrier injection layer 51, the light-emitting layer 50, and the second carrier injection layer 52 that are sequentially stacked as a minimum repetition unit.

The following describes this embodiment of this application with reference to a fabrication process of the LED epitaxial structure. A fabrication method of the LED epitaxial structure includes the following steps.

Step 101: Grow a buffer layer 3 on a wafer (wafer) substrate 2. The wafer substrate 2 may be made of a material such as GaAs, sapphire, or Si, for example, made of a substrate material Si (111), where 111 is a Miller index of the substrate. A growth manner of the buffer layer 3 may be a deposition manner such as metal organic chemical vapor deposition (metal organic chemical vapor deposition, MOCVD) or molecular beam epitaxy (molecular beam epitaxy, MBE). A structure of the buffer layer 3 may be a single functional layer formed by a single material, or a multi-layer composite structure formed by a combination of different materials. For example, an AlN layer 31 and an AlGaN layer 32 are sequentially grown on the Si (111) substrate as the buffer layer 3, and a thickness range of the buffer layer 3 is 0.1-5 µm.

Step 102: Sequentially grow an N^{th} color epitaxial layer 1N to a first color epitaxial layer 11 on the buffer layer 3. That is, a growth direction of the epitaxial layer is opposite to a first direction. For example, when N=3, the third color epitaxial layer 13, the second color epitaxial layer 12, and the first color epitaxial layer 11 are sequentially grown on the buffer layer 3. A growth manner of any one of the first color epitaxial layer 11, the second color epitaxial layer 12, and up to the N^{th} color epitaxial layer 1N may be a deposition manner such as MOCVD or MBE. For example, the second color epitaxial layer 12 may be a green epitaxial layer, and a thickness range of the green epitaxial layer may be 0.1-5 µm, for example, the second color epitaxial layer 12 is 1 µm. The first color epitaxial layer 11 may be a red epitaxial layer, and a thickness range of the red epitaxial layer may be 0.1-10 µm, for example, the first color epitaxial layer 11 is 2 µm. If the LED epitaxial structure includes the third color epitaxial layer 13, the third color epitaxial layer 13 may be a blue epitaxial layer, and a thickness range of the blue epitaxial layer may be 0.1-5 µm, for example, the third color epitaxial layer 13 is 1 µm.

In an epitaxial layer of any color, the first stress buffer layer 41 is configured to annihilate dislocation and improve growth quality. The first stress buffer layer 41 that is first fabricated is directly grown on the buffer layer 3, and gallium nitride may be selected as a material of the first stress buffer layer 41. A thickness range of the first stress buffer layer 41 may be 0.1-3 µm. The first carrier injection layer 51 and the second carrier injection layer 52 are formed by a pair of semiconductor layers with opposite conductivity types. Any one of the first carrier injection layer 51 and the second carrier injection layer 52 may be a single film layer or a multi-layer film. The electron injection layer may be made of electron-doped gallium nitride (n-GaN), and the hole injection layer may be made of hole-doped gallium nitride (p-GaN). A thickness range of the electron injection layer may be 0.1-3 µm, and a doping concentration range is 10¹⁷-10²⁰ cm⁻³. A thickness range of the hole injection layer may be 0.01-3 µm, and a doping concentration range is 10¹⁷-10²⁰ cm⁻³. The doping manner herein and a doping manner of another film layer in this embodiment of this application include uniform doping or gradient doping. The light-emitting layer 50 is sandwiched between the electron injection layer and the hole injection layer. The light-emitting layer 50 may be a single film layer or a multi-layer film. For example, a layer material of indium gallium nitride InGaN multi-quantum well (Multi-Quantum Well, MQW) may be selected as the light-emitting layer 50. For another example, a material of gallium nitride GaN MQW may be selected as the light-emitting layer 50. A thickness range of the light-emitting layer 50 may be 0.001-0.01 µm. The MQW is a periodic structure, and in the structure shown in FIG. 9, a minimum repetition unit of 1 to 20 periods may be grown.

The light-emitting diode LED epitaxial structure in this embodiment of this application includes the at least two monochromatic epitaxial layers that are stacked. Each monochromatic epitaxial layer includes the first stress buffer layer, the first carrier injection layer, the light-emitting layer, and the second carrier injection layer that are sequentially stacked as the minimum repetition unit. That is, color display is implemented by stacking the epitaxial layers of different colors. The color display can be implemented without transferring a monochromatic LED display chip by using a mass transfer technology, and a beam-combining prism or a quantum dot color conversion structure is not required, thereby reducing process limitation on the color display that is implemented by using an LED, and reducing process difficulty.

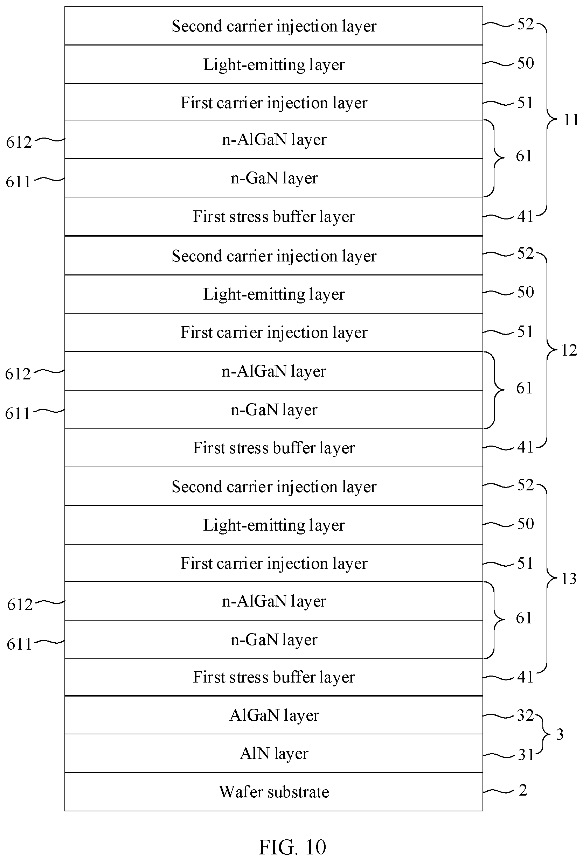

In a possible implementation, as shown in FIG. 10, at least one of the first color epitaxial layer 11 and the second color epitaxial layer 12 further includes an N-type current diffusion layer 61 located on a side that is of the electron injection layer and that is away from the light-emitting layer 50. For example, the first carrier injection layer 51 is the electron injection layer. That is, in a same epitaxial layer, the N-type current diffusion layer 61 is located between the first carrier injection layer 51 and the first stress buffer layer 41. In a structure shown in FIG. 10, three color epitaxial layers are included, where each color epitaxial layer includes a corresponding N-type current diffusion layer 61. The N-type current diffusion layer may include a two-dimensional electron gas (2DEG) structure. The N-type current diffusion layer 61 is configured to improve diffusion uniformity of an injection current on an x-y horizontal plane, and improve light-emitting uniformity of the epitaxial layer. The x-y horizontal plane is, for example, a transverse plane shown in FIG. 10. On a plane of the N-type current diffusion layer 61, electron mobility in an x-y direction is higher than that in a z direction. The N-type current diffusion layer 61 may be a single film layer or a composite structure formed by a multi-layer film. For example, the first carrier injection layer 51 is the electron injection layer, and the second carrier injection layer 52 is the hole injection layer. The N-type current diffusion layer 61 includes an electron-doped gallium nitride n-GaN layer 611 and an electron-doped aluminum gallium nitride n-AlGaN layer 612 that are sequentially stacked and adjacently disposed in the first direction h1. The n-AlGaN layer 612 is in contact with the n-GaN layer 611, to form two-dimensional electron gas that is configured to improve in-plane current diffusion. A thickness range of the n-GaN layer 611 may be 0.1-3 µm, and a doping concentration range is 10¹⁷-10²⁰ cm⁻³. A thickness range of the n-AlGaN layer 612 may be 0.01-0.5 µm, and a doping concentration range is 10¹⁷-10²⁰ cm⁻³. In another possible implementation, an electron-doped aluminum gallium nitride (n-AlGaN) single-layer film may alternatively be selected as the N-type current diffusion layer. A thickness range of the n-AlGaN single-layer film may be 0.01-0.5 µm, and a doping concentration range may be 10¹⁷-10²⁰ cm⁻³. When SF₆ gas is subsequently used to etch the epitaxial structure to form an electrode hole, the SF₆ gas can remove GaN through etching but cannot etch AlGaN. That is, an etching endpoint position is determined by using adjacent GaN and AlGaN, so that an electrode signal is led out through the electrode hole formed through etching, thereby reducing process difficulty.

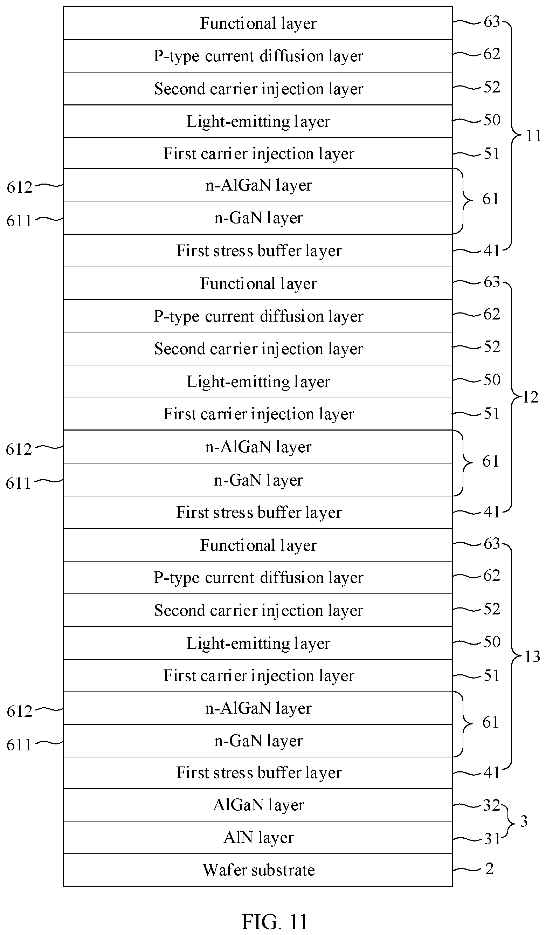

In a possible implementation, as shown in FIG. 11, at least one of the first color epitaxial layer 11 and the second color epitaxial layer 12 further includes a P-type current diffusion layer 62 located on a side that is of the hole injection layer and that is away from the light-emitting layer 50. For example, the second carrier injection layer 52 is the hole injection layer. In a structure shown in FIG. 11, three color epitaxial layers are included, and each color epitaxial layer includes a corresponding P-type current diffusion layer 62. The P-type current diffusion layer 62 is in contact with the hole injection layer at a top layer of the monochromatic epitaxial layer, and a tunneling junction is formed under forward bias, to inject charge carriers into the hole injection layer. That is, the P-type current diffusion layer 62 may include a material that forms, with the hole injection layer, the tunneling junction under forward bias. The P-type current diffusion layer 62 may be made of an electron-doped gallium nitride (n-GaN) material or an electron-doped indium gallium nitride (n-InGaN) material. A thickness range of the P-type current diffusion layer 62 may be 0.001-0.05 µm, and a doping concentration range may be 10¹⁷-10²⁰ cm⁻³. The P-type current diffusion layer 62 is configured to improve diffusion uniformity of injection holes on the x-y horizontal plane, improve light-emitting uniformity of the epitaxial layer, and improve process integration.

In a possible implementation, at least one of the first color epitaxial layer 11 and the second color epitaxial layer 12 further includes a functional layer 63 located on a side that is of the P-type current diffusion layer 62 and that is away from the light-emitting layer. The functional layer 63 is configured to reduce contact resistance and/or configured for wavelength-selective light transmission. The functional layer 63 may be configured to reduce contact resistance and implement electrical interconnection, and may be made of an electron-doped gallium nitride (n-GaN) material. A thickness range of the functional layer 63 may be 0.1-3 µm, and a doping concentration range may be 10¹⁷-10²⁰ cm⁻³. The functional layer 63 may also be configured to implement selective transmission of a specific wavelength. For example, the functional layer 63 is a distributed Bragg reflector (Distributed Bragg reflector, DBR) structure formed by a combination of an electron-doped indium aluminum nitride and gallium nitride, to improve growth quality of the epitaxial layer and a degree of process integration of a device.

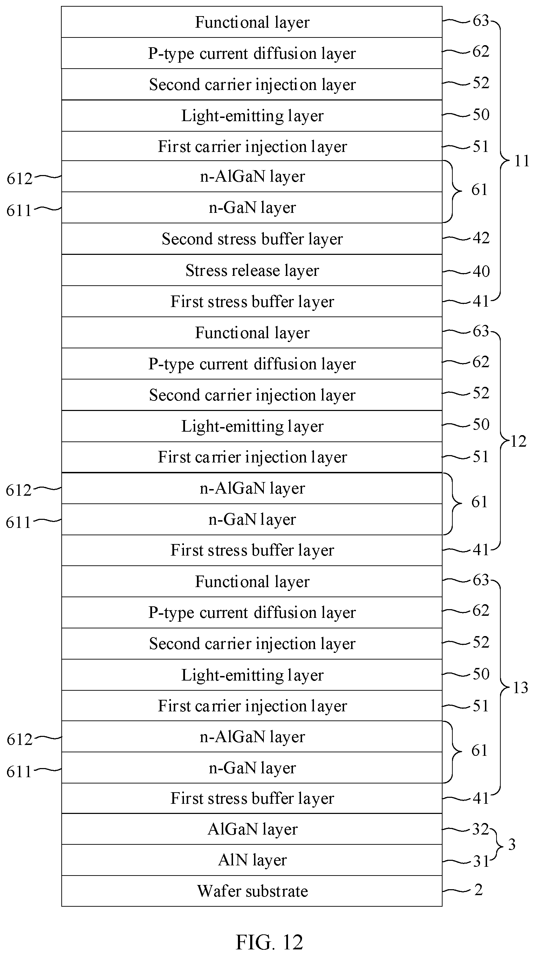

In a possible implementation, as shown in FIG. 12, the light-emitting layer 50 in the first color epitaxial layer 11 is a red light-emitting layer. A stress release layer 40 is disposed between the first stress buffer layer 41 and the first carrier injection layer 51 of the first color epitaxial layer 11. A material of the stress release layer 40 is electron-doped gallium nitride. Because a wavelength of red light is relatively long, during fabrication, the red light-emitting layer requires more doping than a light-emitting layer of another color. For example, if a material of the red light-emitting layer is an indium gallium nitride material, more indium needs to be doped. Therefore, the stress release layer 40 whose material is the electron-doped gallium nitride is added to the first color epitaxial layer 11, so that other required doping may be added in the process of fabricating the red light-emitting layer through stress release action, to improve light-emitting effect of the red light-emitting layer. The stress release layer 40 may be made of an electron-doped gallium nitride (n-GaN) material. A thickness range of the stress release layer 40 may be 0.1-3 µm, and a doping concentration range may be 10¹⁷-10²⁰ cm⁻³.

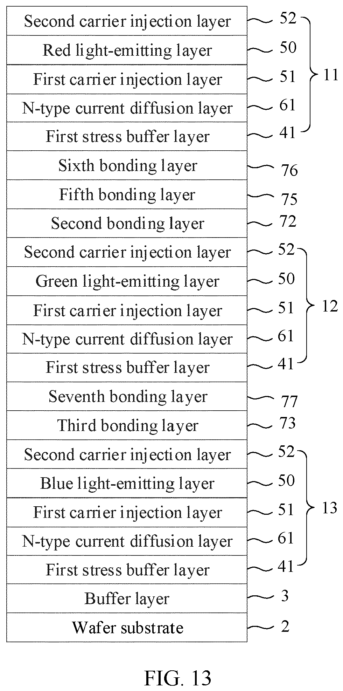

In a possible implementation, as shown in FIG. 13, the LED epitaxial structure further includes at least two bonding layers located between the first color epitaxial layer 11 and the second color epitaxial layer 12.

Specifically, the following describes a fabrication process corresponding to a structure shown in FIG. 13. The structure shown in FIG. 13 includes three color epitaxial layers, and a fabrication method of the LED epitaxial structure includes the following content.

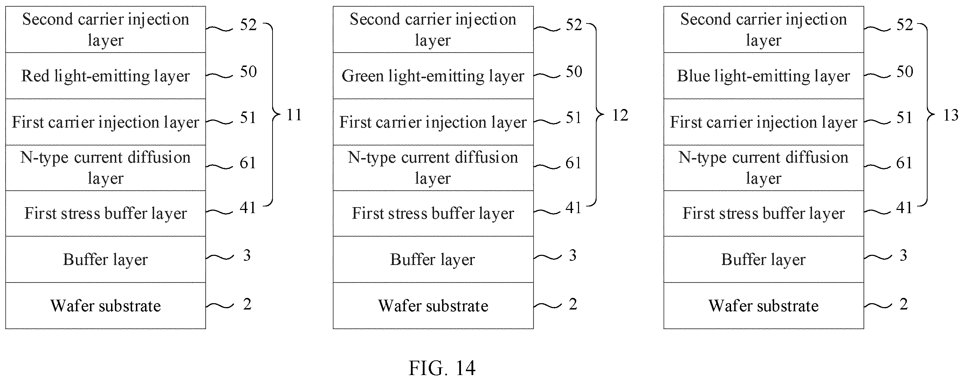

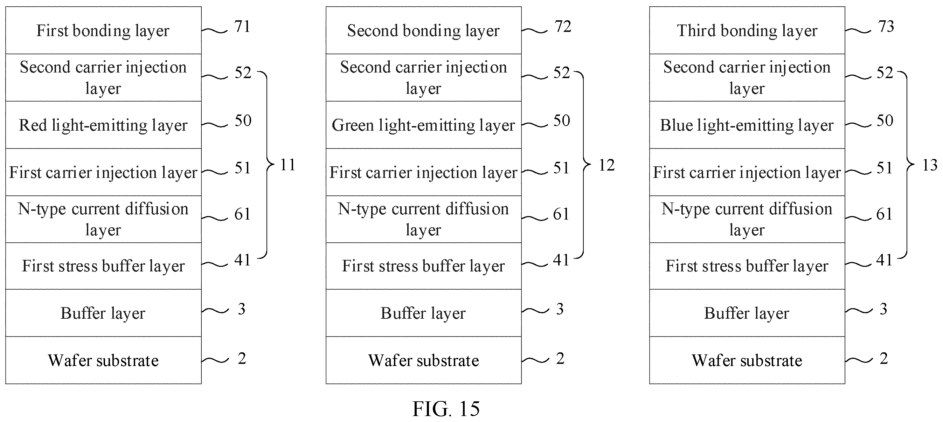

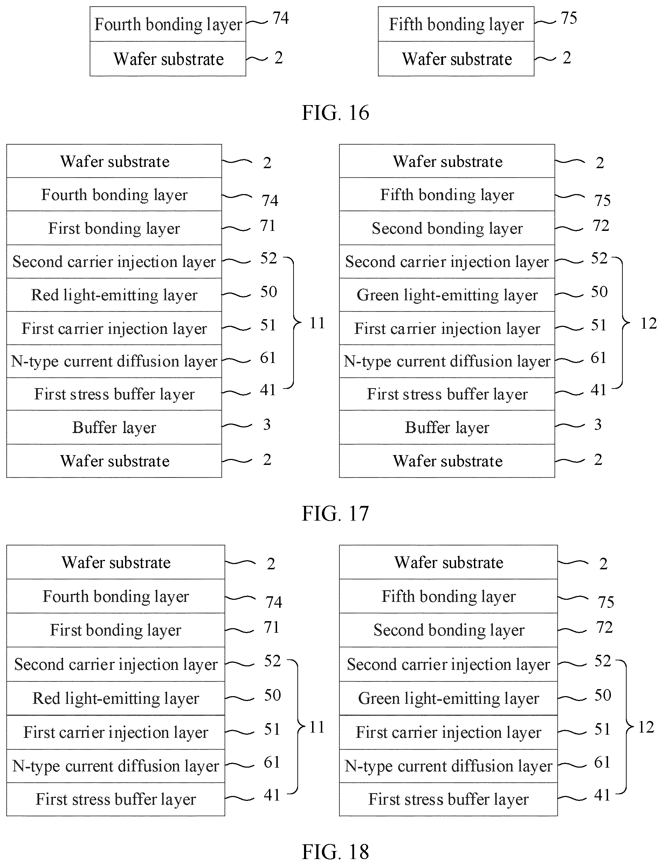

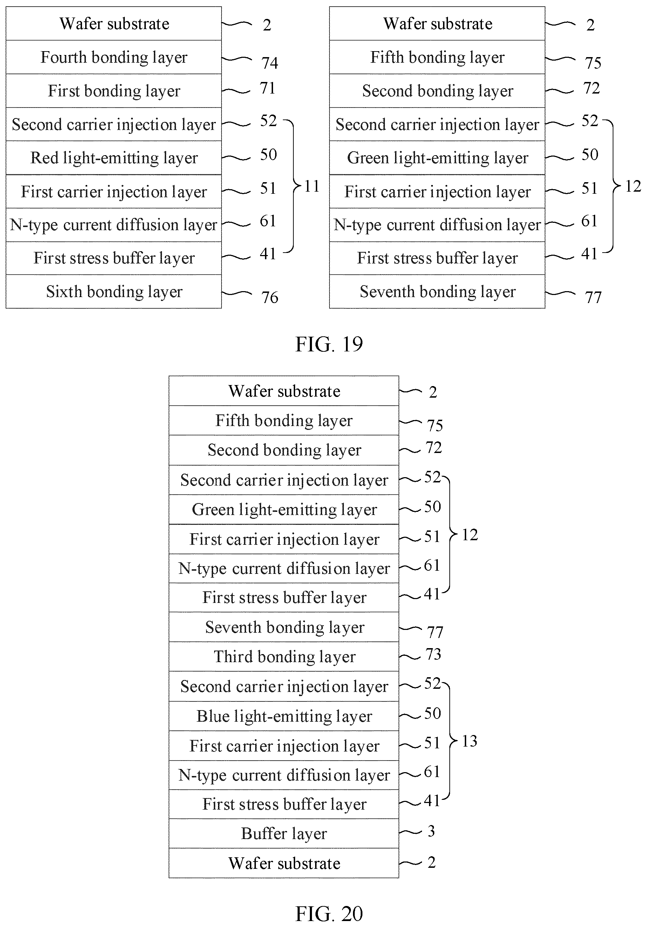

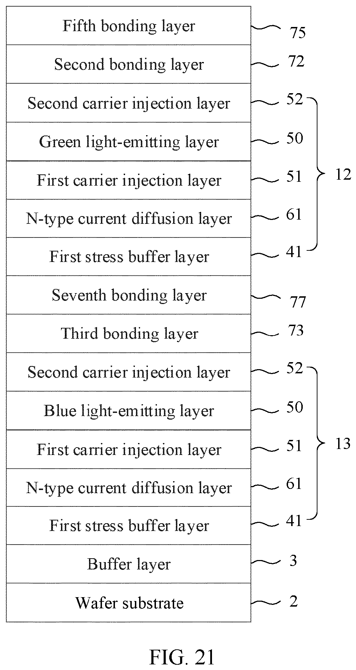

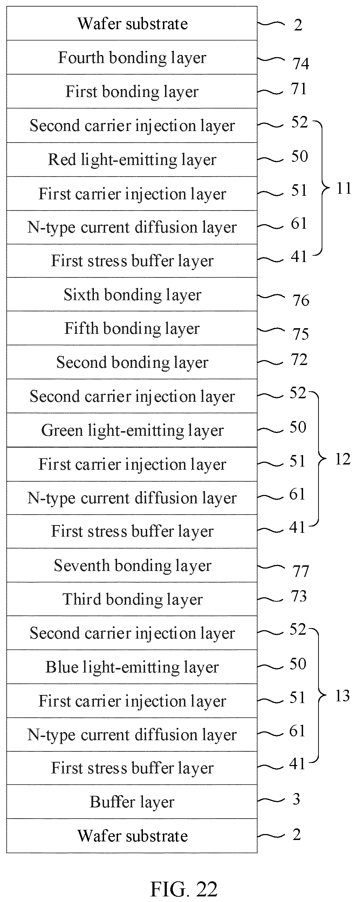

As shown in FIG. 14, three independent epitaxial structures are separately fabricated. Each independent epitaxial structure includes a wafer substrate 2, a buffer layer 3, a first stress buffer layer 41, an N-type current diffusion layer 61, a first carrier injection layer 51, a light-emitting layer 50, and a second carrier injection layer 52 that are sequentially stacked. The light-emitting layers 50 in the three independent epitaxial structures are a red light-emitting layer, a green light-emitting layer, and a blue light-emitting layer. The first stress buffer layer 41, the N-type current diffusion layer 61, the first carrier injection layer 51, the red light-emitting layer 50, and the second carrier injection layer 52 form a first color epitaxial layer 11. The first stress buffer layer 41, the N-type current diffusion layer 61, the first carrier injection layer 51, the green light-emitting layer 50, and the second carrier injection layer 52 form a second color epitaxial layer 12. The first stress buffer layer 41, the N-type current diffusion layer 61, the first carrier injection layer 51, the blue light-emitting layer 50, and the second carrier injection layer 52 form a third color epitaxial layer 13. As shown in FIG. 15, a first bonding layer 71 is fabricated on a surface of the second carrier injection layer 52 of the first color epitaxial layer 11, a second bonding layer 72 is fabricated on a surface of the second carrier injection layer 52 of the second color epitaxial layer 12, and a third bonding layer 73 is fabricated on a surface of the second carrier injection layer 52 of the third color epitaxial layer 13. As shown in FIG. 16, a first temporary substrate including the wafer substrate 2 and a fourth bonding layer 74 is fabricated, and a second temporary substrate including the wafer substrate 2 and a fifth bonding layer 75 is fabricated. As shown in FIG. 17, the first color epitaxial layer 11 is bonded to the first temporary substrate by using the first bonding layer 71 and the fourth bonding layer 74, and the second color epitaxial layer 12 is bonded to the second temporary substrate by using the second bonding layer 72 and the fifth bonding layer 75. As shown in FIG. 18, the buffer layer 3 and the wafer substrate 2 that are on a side that is of the first color epitaxial layer 11 and that is away from the first temporary substrate are removed, and the buffer layer 3 and the wafer substrate 2 that are on a side that is of the second color epitaxial layer 12 and that is away from the second temporary substrate are removed. As shown in FIG. 19, a sixth bonding layer 76 is fabricated on a surface that is of the first color epitaxial layer 11 and that is away from the fourth bonding layer 74, and a seventh bonding layer 77 is fabricated on a surface that is of the second color epitaxial layer 12 and that is away from the fifth bonding layer 75. As shown in FIG. 20, the second color epitaxial layer 12 and the third color epitaxial layer 13 are bonded by using the third bonding layer 73 and the seventh bonding layer 77. As shown in FIG. 21, the wafer substrate 2 on a surface of the fifth bonding layer 75 is removed. As shown in FIG. 22, the first color epitaxial layer 11 and the second color epitaxial layer 12 are bonded by using the second bonding layer 72, the fifth bonding layer 75, and the sixth bonding layer 76. Then, the first bonding layer 71, the fourth bonding layer 74, and the wafer substrate 2 on a surface of the first color epitaxial layer 11 are removed, to form the LED epitaxial structure shown in FIG. 13.

According to the LED epitaxial structure in this embodiment of this application, film layers formed in all epitaxial layer structures may be continuously deposited on a same device.

An embodiment of this application further provides a wafer-level (wafer level) display panel, including the light-emitting diode epitaxial structure, the drive backplane, and the encapsulation structure in the foregoing embodiments. A specific structure and principle of the light-emitting diode epitaxial structure are the same as those in the foregoing embodiments, and details are not described herein again.

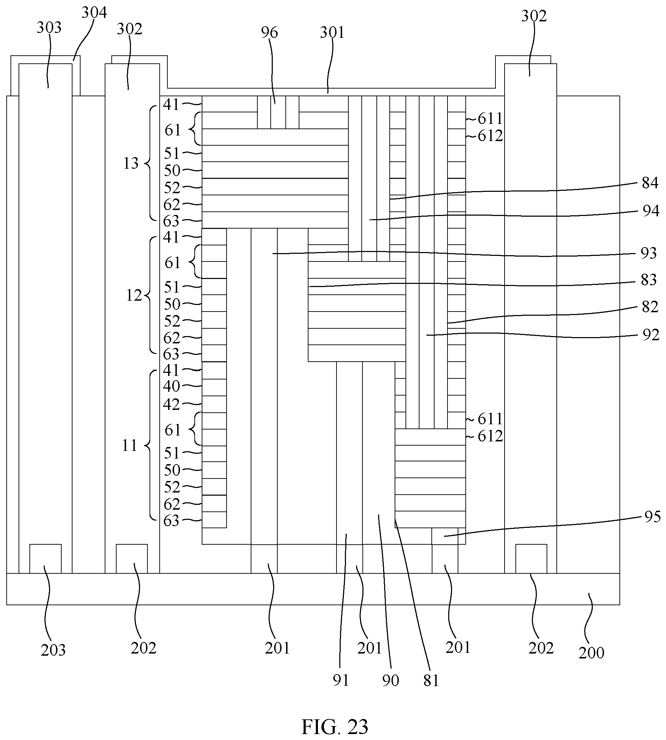

In a possible implementation, the display panel includes a plurality of light-emitting diode epitaxial structures arranged in an array, and the light-emitting diode epitaxial structure is a pixel structure. The LED epitaxial structure in this embodiment of this application includes at least two monochromatic epitaxial layers that are stacked. Therefore, in the display panel including the LED epitaxial structure, to lead out an electrode signal of an LED formed by each monochromatic epitaxial layer, an electrode hole that penetrates through some epitaxial layers are provided. As shown in FIG. 23, in each light-emitting diode epitaxial structure, the first color epitaxial layer 11 has a first electrode hole 81, and the first electrode hole 81 penetrates through the first color epitaxial layer 11 in the first direction. A first conductive structure 91 is disposed in the first electrode hole 81, and the first conductive structure 91 extends from an end that is of the first color epitaxial layer 11 and that is away from the second color epitaxial layer 12 to the second color epitaxial layer 12. An insulation material is filled between the first conductive structure 91 and a side wall of the first electrode hole 81. In each light-emitting diode epitaxial structure, the second color epitaxial layer 12 has a second electrode hole 82, and the second electrode hole 82 penetrates through the second color epitaxial layer 12 in the first direction. A second conductive structure 92 is disposed in the second electrode hole 82, and the second conductive structure 92 extends from an end that is of the second color epitaxial layer 12 and that is away from the first color epitaxial layer 11 to the first color epitaxial layer 11. An insulation material is filled between the second conductive structure 92 and a side wall of the second electrode hole 82. The display panel further includes: a transparent conductive layer 301 located on a side that is of the second color epitaxial layer 12 that is away from the first color epitaxial layer 11, where the transparent conductive layer 301 is electrically connected to the second conductive structure 92 in each light-emitting diode epitaxial structure, and the transparent conductive layer 301 is electrically connected to an end that is of the second color epitaxial layer 12 and that is close to the transparent conductive layer 301 in each light-emitting diode epitaxial structure; and a drive electrode layer located on a side that is of the first color epitaxial layer 11 and that is away from the second color epitaxial layer 12. The drive electrode layer is a first electrode 201. The drive electrode layer includes a first color subpixel electrode corresponding to the first color epitaxial layer 11 in each light-emitting diode epitaxial structure. The first color subpixel electrode is correspondingly electrically connected to the first color epitaxial layer 11 in the corresponding light-emitting diode epitaxial structure. The drive electrode layer includes a second color subpixel electrode corresponding to the second color epitaxial layer 12 in each light-emitting diode epitaxial structure. The second color subpixel electrode is correspondingly electrically connected to the first conductive structure 91 in the corresponding light-emitting diode epitaxial structure.

In a possible implementation, the first color epitaxial layer 11 and the second color epitaxial layer 12 have a third electrode hole 83. The third electrode hole 83 penetrates through the first color epitaxial layer 11 and the second color epitaxial layer 12 in the first direction. A third conductive structure 93 is disposed in the third electrode hole 83, and the third conductive structure 93 extends from the end that is of the first color epitaxial layer 11 and that is away from the second color epitaxial layer 12 to the third color epitaxial layer 13. An insulation material is filled between the third conductive structure 93 and a side wall of the third electrode hole 83. Both the second electrode hole 82 and the second conductive structure 92 penetrate through the third color epitaxial layer 13. The third color epitaxial layer 13 has a fourth electrode hole 84, and the fourth electrode hole 84 penetrates through the third color epitaxial layer 13 in the first direction. A fourth conductive structure 94 is disposed in the fourth electrode hole 84, and the fourth conductive structure 94 extends from the second color epitaxial layer 12 to an end that is of the third color epitaxial layer 13 and that is away from the second color epitaxial layer 12. The third color epitaxial layer 13 is located between the transparent conductive layer 301 and the second color epitaxial layer 12. The transparent conductive layer 301 is electrically connected to an end that is of the third color epitaxial layer 13 and that is close to the transparent conductive layer 301 in each light-emitting diode epitaxial structure. The transparent conductive layer 301 is electrically connected to a fourth conductive structure 94 in each light-emitting diode epitaxial structure. The drive electrode layer includes a third color subpixel electrode corresponding to the third color epitaxial layer 13 in each light-emitting diode epitaxial structure. The third color subpixel electrode is correspondingly electrically connected to the third conductive structure 93 in the corresponding light-emitting diode epitaxial structure. In addition, a fifth conductive structure 95 is further disposed on the side that is of the first color epitaxial layer 11 and that is away from the second color epitaxial layer 12. The fifth conductive structure 95 is connected to a functional layer 63 of the first color epitaxial layer 11. The fifth conductive structure 95 is configured to provide an anode voltage of the first color epitaxial layer 11, and the second conductive structure 92 is configured to provide a cathode voltage of the first color epitaxial layer 11. That is, the first color epitaxial layer 11 is driven to emit light by using the fifth conductive structure 95 and the second conductive structure 92. The first conductive structure 91 is configured to provide an anode voltage of the second color epitaxial layer 12, and the fourth conductive structure 94 is configured to provide a cathode voltage of the second color epitaxial layer 12. That is, the second color epitaxial layer 12 is driven to emit light by using the first conductive structure 91 and the fourth conductive structure 94. A sixth conductive structure 96 is disposed on a side that is of the third color epitaxial layer 13 and that is away from the second color epitaxial layer 12. The sixth conductive structure 96 is connected to an n-AlGaN layer 612 of an N-type current diffusion layer 61 in the third color epitaxial layer 13. The third conductive structure 93 is configured to provide an anode voltage of the third color epitaxial layer 13, and the sixth conductive structure 96 is configured to provide a cathode voltage of the third color epitaxial layer 13. That is, the third color epitaxial layer 13 is driven to emit light by using the third conductive structure 93 and the sixth conductive structure 96.

The following describes a structure shown in FIG. 23 based on a fabrication process.

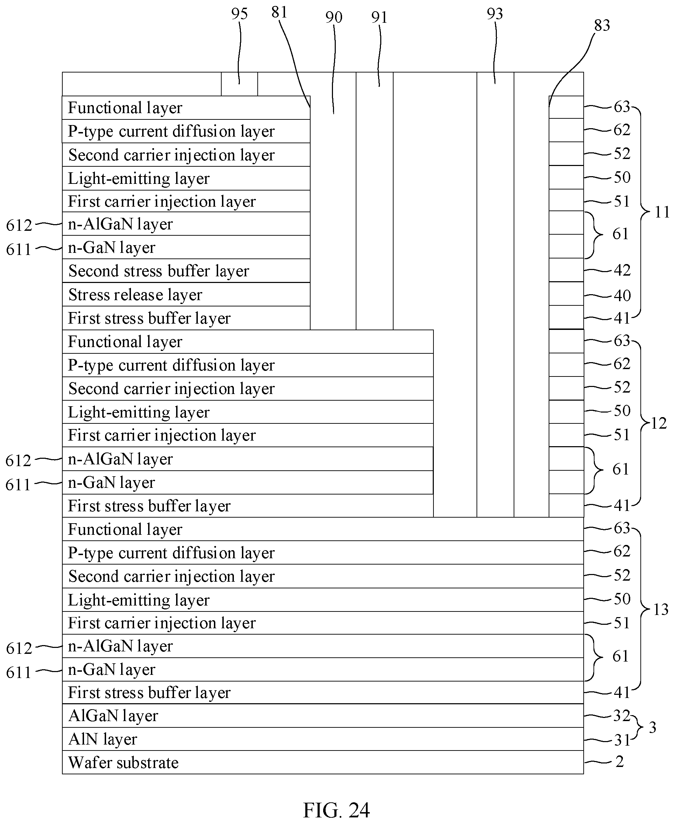

As shown in FIG. 24 to FIG. 29, etching processing is performed on a specific area of the LED epitaxial structure. For example, the first color epitaxial layer 11 is a red epitaxial layer, the second color epitaxial layer 12 is a green epitaxial layer, and the third color epitaxial layer 13 is a blue epitaxial layer. The red epitaxial layer is etched to a functional layer 63 above a P-type current diffusion layer of the green epitaxial layer, the green epitaxial layer is etched to a functional layer 63 above a P-type current diffusion layer of the blue epitaxial layer, to form a pixel pattern (pattern), that is, form the first electrode hole 81 and the third electrode hole 83.

As shown in FIG. 24, photolithography, metal film forming, dielectric film forming, etching, and planarization are performed on the LED epitaxial structure, to fabricate the first conductive structure 91, the third conductive structure 93, and the fifth conductive structure 95. The three structures form an independent p-type addressing unit of one light-emitting pixel. Each light-emitting diode epitaxial structure has an independent p-type addressing unit. The figure shows only one light-emitting diode epitaxial structure. For the finally formed display panel, the display panel includes the plurality of light-emitting diode epitaxial structures arranged in the array. Each light-emitting diode epitaxial structure includes a red light-emitting device, a green light-emitting device, and a blue light-emitting device. Herein, the fifth conductive structure 95 is equivalent to an anode lead of the red light-emitting device, the first conductive structure 91 is equivalent to an anode lead of the green light-emitting device, and the third conductive structure 93 is equivalent to an anode lead of the blue light-emitting device. Because an etching endpoint position of the first electrode hole 81 reaches the second color epitaxial layer 12, the first conductive structure 91 may lead out an anode signal of the second color epitaxial layer 12. Because an etching endpoint position of the third electrode hole 83 reaches the third color epitaxial layer 13, the third conductive structure 93 may lead out an anode signal of the third color epitaxial layer 13.

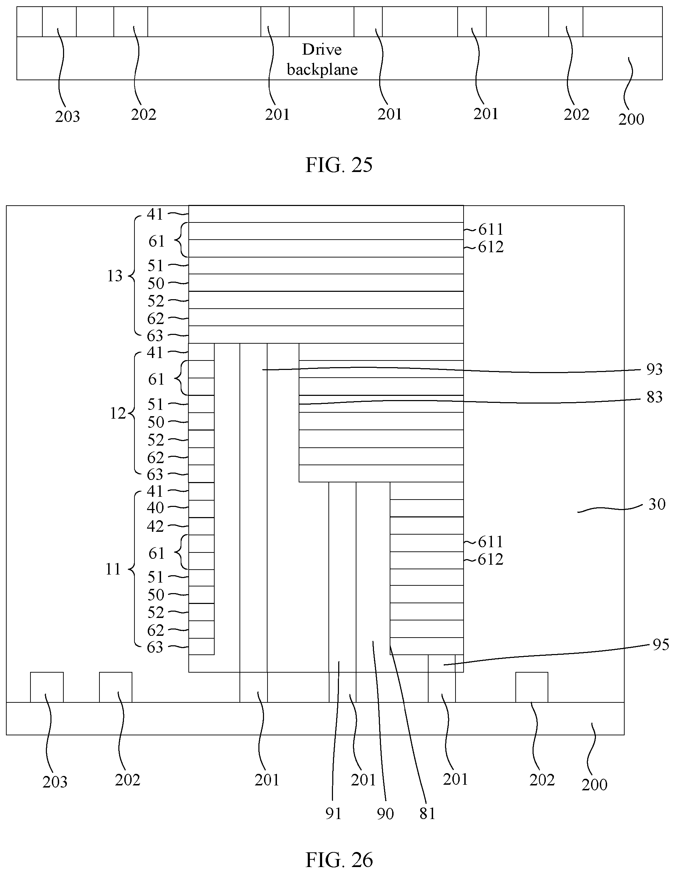

As shown in FIG. 25, the drive backplane is fabricated. The LED epitaxial structure is merely a light-emitting device structure, and needs to cooperate with the drive backplane to implement an active drive display function. The drive backplane 200 includes a functional layer structure such as a drive circuit or a bonding layer. A first electrode 201, a second electrode 202, and a third electrode 203 are disposed on the drive backplane 200 as required. For example, the first electrode 201 is an anode, and is an active addressing electrode. First electrodes 201 are electrically connected to the first conductive structure 91, the third conductive structures 93 and the fifth conductive structures 95 in each LED epitaxial structure (each pixel unit) in a one-to-one correspondence. The second electrode 202 is a cathode, the second electrode 202 is electrically connected to the transparent conductive layer 301 to form a common cathode, and the third electrode 203 is a terminal pad of the drive backplane 200. When the drive backplane 200 is fabricated, the third electrode 203 has been electrically interconnected with the first electrode 201 and the second electrode 202 in the drive backplane. In addition, an insulation film layer for electrical performance insulation is fabricated on a non-electrically interconnected part in the first electrode 201, the second electrode 202, and the third electrode 203. The drive backplane 200 has a plurality of independent third electrodes 203 (only one is shown in FIG. 25). For example, some third electrodes 203 are configured to provide a cathode voltage, some third electrodes 203 are configured to provide an anode voltage, and some third electrodes 203 are configured to provide a control signal of the drive circuit. The drive circuit is configured to drive the epitaxial layer to emit light. Therefore, the epitaxial layer that is on the drive backplane 200 and that corresponds to each color has an independent corresponding first electrode 201.

As shown in FIG. 26, the p-type addressing unit of the LED epitaxial structure shown in FIG. 24 is electrically interconnected with the first electrode 201 of the drive backplane, so that the drive electrodes in the drive backplane 200 are electrically connected to anodes of light-emitting devices of different colors. In addition, the wafer substrate 2 and the buffer layer 3 of the LED epitaxial structure are removed, and a dielectric film 30 is deposited in a peripheral area of a pixel edge.

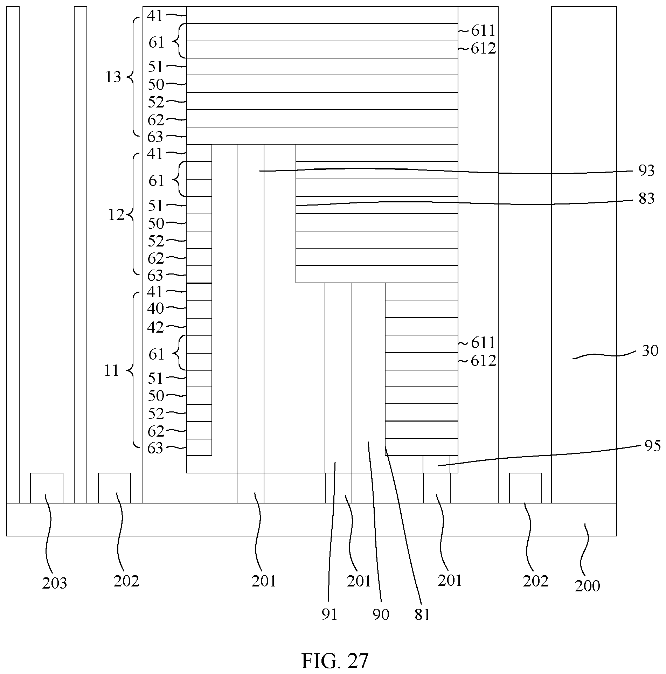

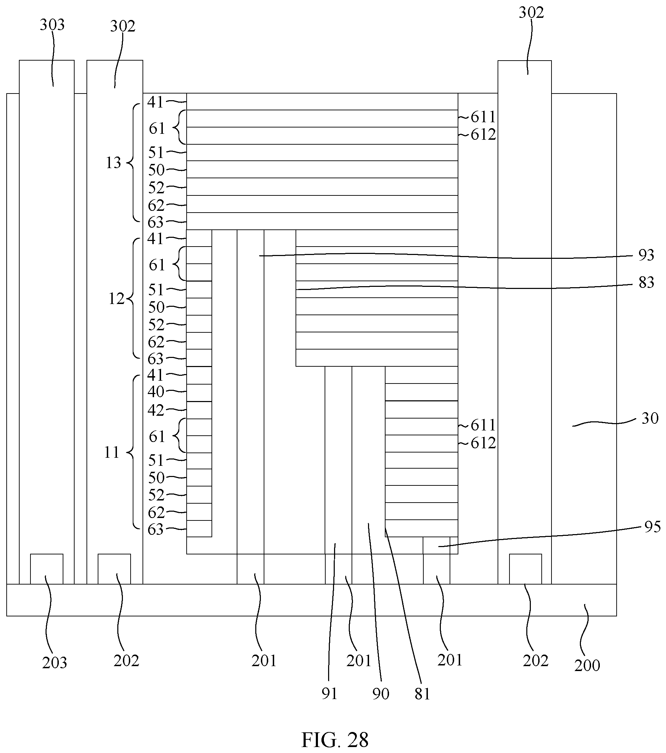

A structure shown in FIG. 26 is formed after the dielectric film 30 is deposited in the peripheral area of the pixel edge, and areas corresponding to the second electrode 202 and the third electrode 203 are etched to form a structure shown in FIG. 27. The etching areas corresponding to the second electrode 202 and the third electrode 203 are filled with metal, including cathode metal 302 electrically connected to the second electrode 202 and lead-out metal 303 electrically connected to the third electrode 203, to form a structure shown in FIG. 28.

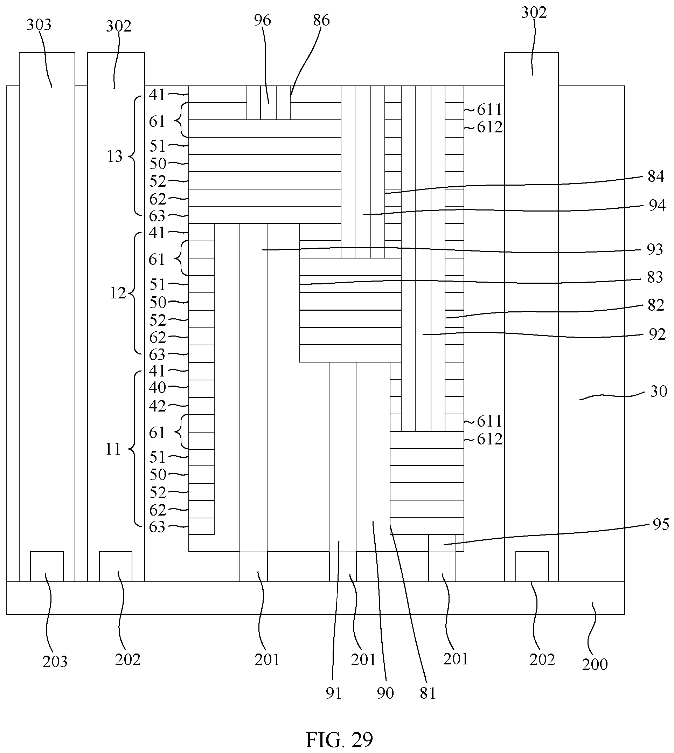

As shown in FIG. 29, specific pixel positions are etched to form the second electrode hole 82, the fourth electrode hole 84, and the sixth electrode hole 86. An etching endpoint position of a hole herein is a position between the n-AlGaN layer 612 and the n-GaN layer 611 in the foregoing embodiment. For example, an etching endpoint position of the second electrode hole 82 is an n-AlGaN layer 612 of an N-type current diffusion layer 61 in the first color epitaxial layer 11. An etching endpoint position of the fourth electrode hole 84 is an n-AlGaN layer 612 of an N-type current diffusion layer 61 in the second color epitaxial layer 12. An etching endpoint position of the sixth electrode hole 86 is the n-AlGaN layer 612 of the N-type current diffusion layer 61 in the third color epitaxial layer 13. Then, the second conductive structure 92 in contact with the n-AlGaN layer 612 in the first color epitaxial layer 11, the fourth conductive structure 94 in contact with the n-AlGaN layer 612 in the second color epitaxial layer 12, and the sixth conductive structure 96 in contact with the n-AlGaN layer 612 in the third color epitaxial layer 13 are formed, and an insulation material is filled between each conductive structure and a hole side wall. In this way, the second conductive structure 92, the fourth conductive structure 94, and the sixth conductive structure 96 may lead out a cathode signal of each epitaxial layer.

As shown in FIG. 23, the transparent conductive layer 301 is deposited to form a common N contact. To be specific, the transparent conductive layer 301 is connected to the second conductive structure 92, the fourth conductive structure 94, the sixth conductive structure 96, and the cathode metal 302 that corresponds to the second electrode 202. In addition, metal is deposited on a surface of the lead-out metal 303 to form a pad electrode 304. The pad electrode 304 is configured to connect to an external chip, a flexible circuit board, or the like. The pad electrode used to provide a cathode voltage is electrically interconnected with the transparent conductive layer 301.

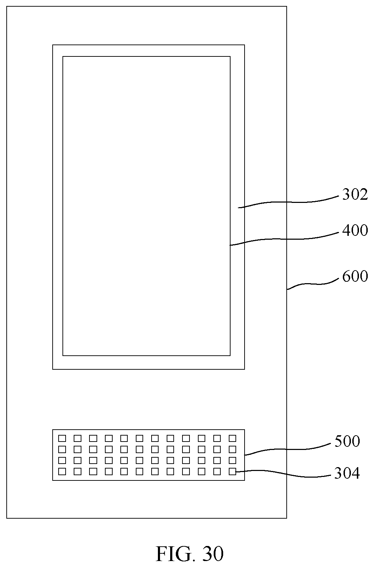

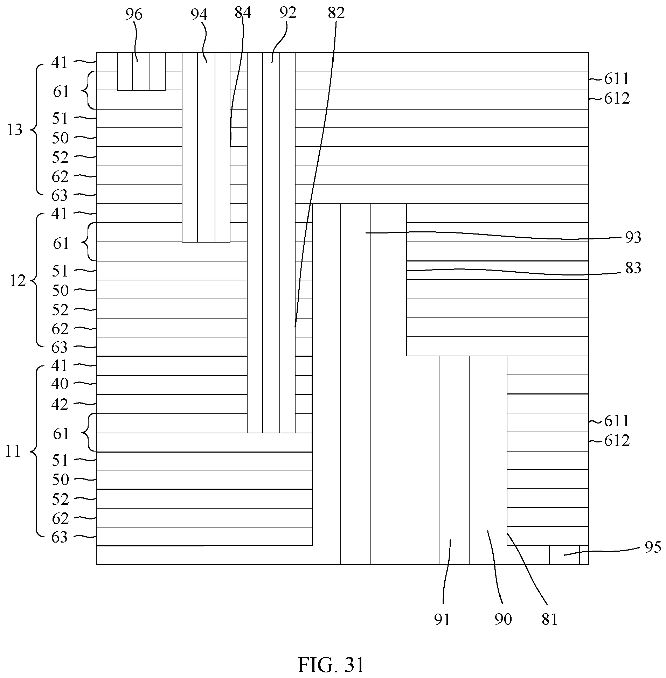

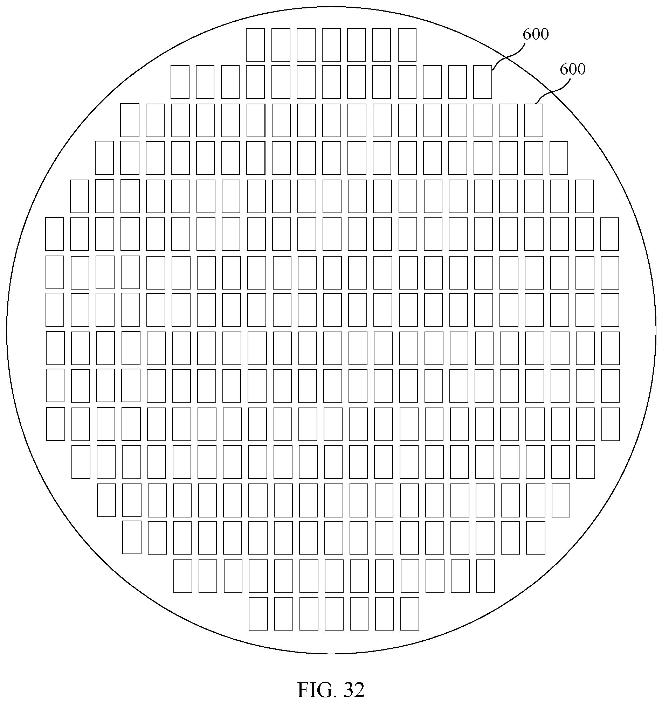

So far, the LED display panel based on the LED epitaxial structure is fabricated. As shown in FIG. 30, a display panel 600 includes a display area 400 and a pad electrode area 500. The display area 400 includes a plurality of LED epitaxial light-emitting diode epitaxial structures arranged in an array. At least a part of a cross-section of each light-emitting diode epitaxial structure may be a structure shown in FIG. 31. Each LED epitaxial light-emitting diode epitaxial structure includes an independent p-type addressing unit. The plurality of LED epitaxial light-emitting diode epitaxial structures are in a one-to-one correspondence with anode area addressing units (the first electrodes 201) of the drive backplane in the display area 400, and an annular common N contact is formed on an outer side of the display area 400. To be specific, cathode conductive structures of the plurality of LED epitaxial light-emitting diode epitaxial structures are all connected to the drive backplane by using the transparent conductive layer and the cathode metal 302 that is on the outer side of the display area 400, to implement interconnection between the LED epitaxial structure and a cathode area (a second electrode 202) of the drive backplane. In this way, light-emitting devices of different colors in the LED epitaxial structures can be driven through the drive backplane. In addition, a third electrode 203 is connected to an upper surface of the overall display panel in the lead-out area 500 through lead-out metal 303, and deposits metal on a surface of the lead-out metal 303 to form a pad electrode 304, so that the pad electrode 304 is electrically connected to a flexible circuit board (Flexible Printed Circuit, FPC) or a drive chip. The pad electrode area 500 is an area in which the pad electrode 304 is disposed. The pad electrode area 500 may be disposed on one side of the display area 400 as shown in FIG. 30, or may be disposed at another position, or may be disposed at a plurality of positions. A specific manner of disposing the pad electrode area 500 is not limited in this embodiment of this application. As shown in FIG. 32, in a process of fabricating the display panel, a plurality of display panels 600 are usually fabricated on a same substrate, and then an independent display panel 600 may be obtained by cutting. FIG. 32 is merely a diagram. During actual arrangement, adjacent display panels 600 are closely arranged, and a cutting lane of 80-200 µm is reserved between the adjacent display panels 600, to improve overall layout density of a wafer.

In a possible implementation, a material of the light-emitting layer 50 is indium gallium nitride multi-quantum well, and the light-emitting layer 50 may include a superlattice layer.

In a possible implementation, a material of the first stress buffer layer 41 is gallium nitride; a material of the first carrier injection layer 51 is electron-doped gallium nitride; and a material of the second carrier injection layer 52 is hole-doped gallium nitride. The hole injection layer in this embodiment of this application may include an electron blocking layer.

In a possible implementation, the N-type current diffusion layer 61 includes the electron-doped gallium nitride layer 611 and the electron-doped aluminum gallium nitride layer 612 that are sequentially stacked in the first direction.

In a possible implementation, a material of the functional layer 63 is electron-doped gallium nitride n-GaN, or the functional layer 63 is a distributed Bragg reflector DBR structure formed by a combination of electron-doped indium aluminum nitride n-InAlN and gallium nitride GaN.

In a possible implementation, the light-emitting diode epitaxial structure further includes a second stress buffer layer 42 located between the stress release layer 40 and the first carrier injection layer 51. A material of the stress release layer 40 is electron-doped gallium nitride. Materials of the first stress buffer layer 41 and the second stress buffer layer 42 are unintentionally doped gallium nitride u-GaN.

An embodiment of this application further provides an electronic device, including the display panel 600 in the foregoing embodiment. A specific structure and principle of the display panel are the same as those in the foregoing embodiment, and details are not described herein again. The electronic device may be any electronic device having a display function, such as an AR device, a VR device, a mobile phone, or a tablet computer.

In embodiments of this application, "at least one" means one or more, and "a plurality of" means two or more. The term "and/or" describes an association relationship for describing associated objects and represents that three relationships may exist. For example, A and/or B may represent the following cases: Only A exists, both A and B exist, and only B exists. A and B may be singular or plural. The character "/" generally indicates an "or" relationship between the associated objects. "At least one of the following terms" and similar expressions means any combination of these terms, including any combination of single or plural terms. For example, at least one of a, b, or c may indicate: a, b, c, a and b, a and c, b and c, or a, b, and c, where a, b, and c may be singular or plural.

The foregoing descriptions are merely preferred embodiments of this application, and are not intended to limit this application. For a person skilled in the art, this application may have various modifications and variations. Any modification, equivalent replacement, or improvement made without departing from the spirit and principle of this application shall fall within the protection scope of this application.

## Claims

1. A light-emitting diode epitaxial structure, comprising:
a first color epitaxial layer and a second color epitaxial layer that are stacked, wherein
any one of the first color epitaxial layer and the second color epitaxial layer comprises a first stress buffer layer, a first carrier injection layer, a light-emitting layer, and a second carrier injection layer that are sequentially stacked in a first direction;
the light-emitting layers in the first color epitaxial layer and the second color epitaxial layer are light-emitting layers of different colors; and
one of the first carrier injection layer and the second carrier injection layer is an electron injection layer, and the other of the first carrier injection layer and the second carrier injection layer is a hole injection layer.

2. The light-emitting diode epitaxial structure according to claim 1, wherein
at least one of the first color epitaxial layer and the second color epitaxial layer further comprises an N-type current diffusion layer located on a side that is of the electron injection layer and that is away from the light-emitting layer.

3. The light-emitting diode epitaxial structure according to claim 1, wherein
at least one of the first color epitaxial layer and the second color epitaxial layer further comprises a P-type current diffusion layer located on a side that is of the hole injection layer and that is away from the light-emitting layer.

4. The light-emitting diode epitaxial structure according to claim 3, wherein
at least one of the first color epitaxial layer and the second color epitaxial layer further comprises a functional layer located on a side that is of the P-type current diffusion layer and that is away from the light-emitting layer, wherein the functional layer is configured to reduce contact resistance and/or configured for wavelength-selective light transmission.

5. The light-emitting diode epitaxial structure according to claim 2, wherein
the N-type current diffusion layer comprises a two-dimensional electron gas structure.

6. The light-emitting diode epitaxial structure according to claim 2, wherein
the first carrier injection layer is the electron injection layer, the second carrier injection layer is the hole injection layer, and the N-type current diffusion layer comprises an electron-doped gallium nitride layer and an electron-doped aluminum gallium nitride layer that are sequentially stacked and adjacently disposed in the first direction.

7. The light-emitting diode epitaxial structure according to claim 1, wherein
the light-emitting layer in the first color epitaxial layer is a red light-emitting layer; and
a stress release layer is disposed between the first stress buffer layer and the first carrier injection layer of the first color epitaxial layer, and a material of the stress release layer is electron-doped gallium nitride.

8. The light-emitting diode epitaxial structure according to claim 7, wherein
a thickness range of the stress release layer is [0.1, 3] µm.

9. The light-emitting diode epitaxial structure according to claim 1, further comprising:
at least two bonding layers located between the first color epitaxial layer and the second color epitaxial layer.

10. The light-emitting diode epitaxial structure according to claim 1, further comprising:
a third color epitaxial layer located on a side that is of the second color epitaxial layer and that is away from the first color epitaxial layer, wherein
the third color epitaxial layer comprises a first stress buffer layer, a first carrier injection layer, a light-emitting layer, and a second carrier injection layer that are sequentially stacked in the first direction, and the light-emitting layers of any two of the first color epitaxial layer, the second color epitaxial layer, and the third color epitaxial layer are light-emitting layers of different colors.

11. The light-emitting diode epitaxial structure according to any one of claims 1 to 10, wherein
a material of the light-emitting layer is indium gallium nitride multi-quantum well.

12. The light-emitting diode epitaxial structure according to any one of claims 1 to 10, wherein
a material of the first stress buffer layer is gallium nitride;
a material of the first carrier injection layer is electron-doped gallium nitride; and
a material of the second carrier injection layer is hole-doped gallium nitride.

13. The light-emitting diode epitaxial structure according to claim 3, wherein
the P-type current diffusion layer comprises a material that forms, with the hole injection layer, a tunneling junction under forward bias.

14. The light-emitting diode epitaxial structure according to claim 4, wherein
a material of the functional layer is electron-doped gallium nitride, or the functional layer is a distributed Bragg reflector structure formed by a combination of electron-doped indium aluminum nitride and gallium nitride.

15. The light-emitting diode epitaxial structure according to claim 7, further comprising:
a second stress buffer layer located between the stress release layer and the first carrier injection layer, wherein
the material of the stress release layer is the electron-doped gallium nitride; and
materials of the first stress buffer layer and the second stress buffer layer are unintentionally doped gallium nitride.

16. A display panel, comprising the light-emitting diode epitaxial structure according to any one of claims 1 to 15.

17. The display panel according to claim 16, wherein
the display panel comprises a plurality of light-emitting diode epitaxial structures arranged in an array, wherein
in each light-emitting diode epitaxial structure, the first color epitaxial layer has a first electrode hole, the first electrode hole penetrates through the first color epitaxial layer in the first direction, a first conductive structure is disposed in the first electrode hole, and the first conductive structure extends from an end that is of the first color epitaxial layer and that is away from the second color epitaxial layer to the second color epitaxial layer;
an insulation material is filled between the first conductive structure and a side wall of the first electrode hole;
in each light-emitting diode epitaxial structure, the second color epitaxial layer has a second electrode hole, the second electrode hole penetrates through the second color epitaxial layer in the first direction, a second conductive structure is disposed in the second electrode hole, and the second conductive structure extends from an end that is of the second color epitaxial layer and that is away from the first color epitaxial layer to the first color epitaxial layer; and
an insulation material is filled between the second conductive structure and a side wall of the second electrode hole; and
the display panel further comprises:
a transparent conductive layer located on a side that is of the second color epitaxial layer and that is away from the first color epitaxial layer, wherein the transparent conductive layer is electrically connected to the second conductive structure in each light-emitting diode epitaxial structure; and
the transparent conductive layer is electrically connected to an end that is of the second color epitaxial layer and that is close to the transparent conductive layer in each light-emitting diode epitaxial structure; and
a drive electrode layer located on a side that is of the first color epitaxial layer and that is away from the second color epitaxial layer, wherein
the drive electrode layer comprises a first color subpixel electrode corresponding to the first color epitaxial layer in each light-emitting diode epitaxial structure, and the first color subpixel electrode is correspondingly electrically connected to the first color epitaxial layer in the corresponding light-emitting diode epitaxial structure; and
the drive electrode layer comprises a second color subpixel electrode corresponding to the second color epitaxial layer in each light-emitting diode epitaxial structure, and the second color subpixel electrode is correspondingly electrically connected to the first conductive structure in the corresponding light-emitting diode epitaxial structure.

18. The display panel according to claim 17, wherein
the first color epitaxial layer and the second color epitaxial layer have a third electrode hole, the third electrode hole penetrates through the first color epitaxial layer and the second color epitaxial layer in the first direction, a third conductive structure is disposed in the third electrode hole, and the third conductive structure extends from the end that is of the first color epitaxial layer and that is away from the second color epitaxial layer to the third color epitaxial layer;
an insulation material is filled between the third conductive structure and a side wall of the third electrode hole;
both the second electrode hole and the second conductive structure penetrate through the third color epitaxial layer;
the third color epitaxial layer has a fourth electrode hole, the fourth electrode hole penetrates through the third color epitaxial layer in the first direction, a fourth conductive structure is disposed in the fourth electrode hole, and the fourth conductive structure extends from the second color epitaxial layer to an end that is of the third color epitaxial layer and that is away from the second color epitaxial layer;
the third color epitaxial layer is located between the transparent conductive layer and the second color epitaxial layer;
the transparent conductive layer is electrically connected to an end that is of the third color epitaxial layer and that is close to the transparent conductive layer in each light-emitting diode epitaxial structure;
the transparent conductive layer is electrically connected to the fourth conductive structure in each light-emitting diode epitaxial structure; and
the drive electrode layer comprises a third color subpixel electrode corresponding to the third color epitaxial layer in each light-emitting diode epitaxial structure, and the third color subpixel electrode is correspondingly electrically connected to the third conductive structure in the corresponding light-emitting diode epitaxial structure.

19. An electronic device, comprising the display panel according to any one of claims 16 to 18.
